# EUROPÄISCHE PATENTSCHRIFT

(11) **EP 1 177 634 B1**
(45) Veröffentlichungstag und Bekanntmachung des Hinweises auf die Patenterteilung: **29.09.2004**
(21) Anmeldenummer: 00940154.8
(22) Anmeldetag: 27.04.2000
(51) Int. Cl.: H03M 3/04

(54) **SIGMA-DELTA-ANALOG/DIGITAL-WANDLERANORDNUNG**
SIGMA-DELTA ANALOG/DIGITAL CONVERTER ARRAY
ENSEMBLE CONVERTISSEUR SIGMA-DELTA-ANALOGIQUE/NUMERIQUE

(30) Priorität: 05.05.1999 DE 19920738
(43) Veröffentlichungstag der Anmeldung: 06.02.2002
(73) Patentinhaber: Infineon Technologies AG, 81669 München (DE)
(72) Erfinder: WIESBAUER, Andreas, A-9210 Pörtschach (AT); WEINBERGER, Hubert, A-8540 Soboth (AT); CLARA, Martin, A-9500 Villach (AT); HAUPTMANN, Jörg, A-9241 Wernberg (AT)
(74) Vertreter: Banzer, Hans-Jörg, Dipl.-Ing.
(86) Internationale Anmeldenummer: PCT/DE2000/001325
(87) Internationale Veröffentlichungsnummer: WO 2000/069078

(56) Entgegenhaltungen:
- EP-A- 0 450 951
- US-A- 5 736 950
- HARRIS F J ET AL: "IMPLEMENTATION CONSIDERATIONS AND LIMITATIONS FOR DYNAMIC RANGE ENHANCED ANALOG TO DIGITAL CONVERTERS" INTERNATIONAL CONFERENCE ON ACOUSTICS, SPEECH & SIGNAL PROCESSING. ICASSP,US,NEW YORK, IEEE, Bd. CONF. 14, 23. Mai 1989 (1989-05-23), Seiten 1286-1289, XP000090338

## Beschreibung

Die vorliegende Erfindung betrifft eine Sigma-Delta-Analog/Digital-Wandleranordnung, insbesondere eine kaskadierte zweistufige Sigma-Delta-Analog/Digital-Wandleranordnung nach dem Oberbegriff des Anspruches 1.

In vielen xDSL-Anwendungen werden (nachfolgend abgekürzt als AD-Wandler bezeichnete) Analog/Digital-Wandler mit hoher Auflösung und guter Bandbreite benötigt.

Diesbezüglich sind sogenannte Pipelinearchitekturen mit mehreren Flash-AD-Wandlern bekannt. Derartige Pipelinearchitekturen erlauben sehr hohe Bandbreiten und entsprechend hohe Abtastraten bei guter Signalauflösung. Pipelinearchitekturen benötigen jedoch in der Regel Autokalibirierungsmechanismen, die auf demselben Chip wie die AD-Wandleranordnung vorzusehen sind und demzufolge die Komplexität der Schaltung und die benötigte Siliziumfläche vergrößern.

Daher werden vorteilhafterweise Sigma-Delta-Wandler verwendet, die durch Überabtastung einen höheren Dynamikbereich erzielen, was jedoch in der Regel eine verringerte Signalbandbreite zur Folge hat. Um ohne Vergrößerung der Abtastrate die verfügbare Signalbandbreite zu erhöhen, muß daher die Überabtastrate (Oversampling Rate, OSR) verringert werden. Bei niedrigen Überabtastraten ist jedoch nur dann ein zufriedenstellender Betrieb möglich, wenn das durch die in Sigma-Delta-Wandlern verwendeten Quantisierer hervorgerufene Quantisierungsrauschen ausreichend gering ist.

Die in Einbit-Sigma-Delta-Wandler verwendeten Einbit-Quantisierer erzeugen jedoch relativ große Quantisierungsfehler, so daß mit Hilfe eines Einbit-Sigma-Delta-Wandlers nur sehr schwer ein guter Signalrauschabstand bei niedriger Überabtastrate erzielt werden kann. Darüber hinaus benötigen Einbit-Sigma-Delta-Wandlerarchitekturen, obwohl sie lediglich eine geringe Siliziumfläche erfordern, aufgrund der relativ hohen Abtastraten große Versorgungströme.

Dagegen besitzen Multibit-Sigma-Delta-Wandlerarchitekturen, die lediglich etwas größer als Einbit-Sigma-Delta-Wandlerarchitekturen sind, einen deutlich geringeren Stromverbrauch, da sie geringere Abtastfrequenzen ermöglichen. Durch die Verwendung einer Multibit-Rückkopplung kann bei lediglich geringen Überabtastraten ein hoher Signalrauschabstand erzielt werden. Multibit-Sigma-Delta-Wandler können somit für alle Anwendungen verwendet werden, bei denen sowohl eine hohe Auflösung als auch eine hohe Wandlergeschwindigkeit gefordert ist. Multibit-Sigma-Delta-Wandler schließen somit die Lücke zwischen den zuvor erwähnten Flash-Wandlern, die bei begrenzter Auflösung hohe Geschwindigkeiten ermöglichen, und Einbit-Sigma-Delta-Wandlern, die eine hohe Auflösung bei mittleren Geschwindigkeiten erlauben.

Die Implementierung eines leistungsfähigen Multibit-Sigma-Delta-Wandlers stellt hinsichtlich verschiedener Aspekte eine Herausforderung dar. Einer dieser Aspekte ist die Aufgabe, eine Architektur zu entwickeln, welche eine flächeneffiziente Implementierung der internen AD- und DA-Wandler des Sigma-Delta-Wandlers ermöglicht. Da die AD- und DA-Wandler üblicherweise in Serie innerhalb der Rückkopplungsschleife der entsprechenden Sigma-Delta-Wandlerarchitektur geschaltet sind, entspricht die maximal zulässige Wandlerzeit für jeden Wandler lediglich der halben Taktperiode. Flächeneffiziente Implementierungen, wie z.B. Pipelinestrukturen, können somit aufgrund ihrer Eigenlatenz oder Eigenansprechzeit nicht für interne AD-Wandler verwendet werden.

Des weiteren sind herkömmliche einstufige Multibit-Sigma-Delta-Wandler mit einer internen Quantisierung größer als beispielsweise 5Bit hinsichtlich ihres Siliziumflächenbedarfs nachteilig, obwohl sie bezüglich ihres Stromverbrauchs sehr vorteilhaft wären.

Ein weiteres mit Multibit-Sigma-Delta-Wandlerarchitekturen verbundenes Problem stellt die Tatsache dar, daß in der Rückkopplungsschleife dieser Architekturen zwangläufig einer oder mehrere Multibit-DA-Wandler verwendet werden müssen, wobei mit einer derartigen Mutibit-Rückkopplung jedoch Linearitätsprobleme verbunden sind.

Um dieses Problem zu beheben, wurde in "An Improved Sigma-Delta Modulator Architecture", T.C. Leslie und B. Singh, IEEE Proceedings ISCAS'90, Seiten 372-375, Mai 1990, vorgeschlagen, von dem Multibit-Ausgangssignal des AD-Wandlers die niederwertigen Bits abzuschneiden und nur das höchstwertige Bit über die Rückkopplungsschleife zurückzuführen, so daß lediglich ein Einbit-DA-Wandler im Rückkopplungszweig verwendet werden muß. Die niederwertigeren Bits werden digital verarbeitet und mit dem Ausgangssignal des Sigma-Delta-Wandlers kombiniert, um den sich durch das Abschneiden der niederwertigeren Bits ergebenden Fehler im Rückkopplungssignal zu minimieren.

Eine weitere Möglichkeit zur Verringerung des Quantisierungsrauschens bei Verwendung von Multibit-Sigma-Delta-Wandlerarchitekturen ist der Einsatz mehrerer Sigma-Delta-Wandlerstufen, welche kaskadenartig verschaltet werden. Bei derartigen kaskadierten Sigma-Delta-Wandlerarchitekturen wird der Quantisierungsfehler einer Stufe in der nachfolgenden Stufe verarbeitet und die digitalen Ausgangssignale der einzelnen Stufen zur Rauschunterdrückung digital verarbeitet. Derartige kaskadierten Sigma-Delta-Wandler werden auch als MASH-Sigma-Delta-Wandler bezeichnet.

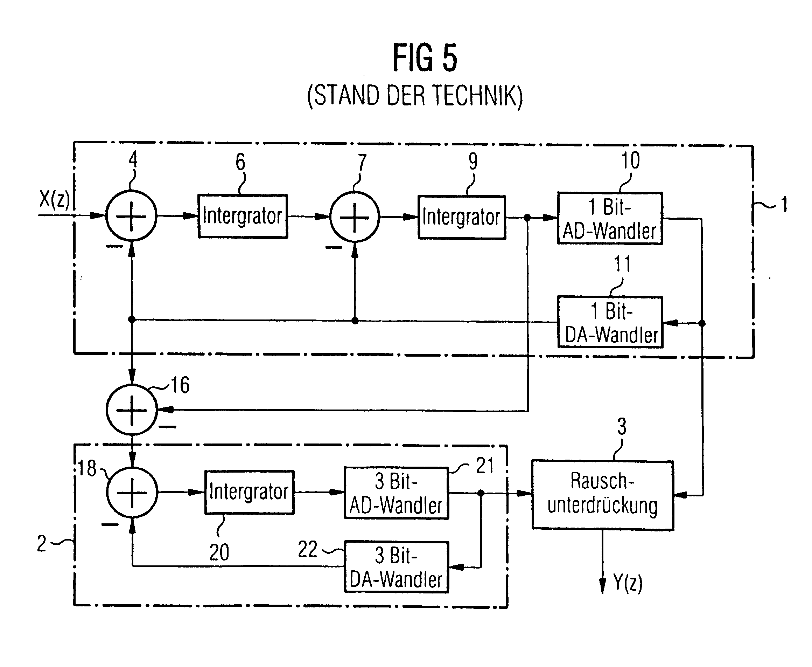

In Fig. 5 ist ein vereinfachtes Blockschaltbild einer derartigen kaskadierten zweistufigen Sigma-Delta-Wandlerarchitektur dargestellt, wie sie insbesondere in "A 50MHz Multibit Sigma-Delta Modulator for 12b 2MHZ A/D Conversion", B.P. Brandt, B.A. Wolley, IEEE Journal of Solid-State Circuits, vol. 26, Dezember 1991, beschrieben ist. Diese Architektur umfaßt zwei kaskadenartig verschaltete Sigma-Delta-Wandlerstufen oder Sigma-Delta-Modulatoren 1 und 2, wobei die erste Wandlerstufe 1 einem Einbit-Sigma-Delta-Wandler zweiter Ordnung und die zweite Wandlerstufe 2 einem Multibit-Sigma-Delta-Wandler erster Ordnung entspricht. Die erste Wandlerstufe 1 umfaßt demzufolge gemäß Fig. 5 zwei Integratoren 6, 9 in Form von SC-Filtern (Switched Capacitor), die zusammen mit einem 1Bit-AD-Wandler 10 im Vorwärtspfad der ersten Wandlerstufe 1 angeordnet sind. Das digitale Ausgangssignal des 1Bit-AD-Wandlers 10 wird, wie es für Sigma-Delta-Wandler üblich ist, über einen im Rückkopplungszweig befindlichen 1Bit-DA-Wandler 11 über Addierer 4 und 7 derart zurückgeführt, daß den Integratoren 6 und 9 jeweils die Differenz zwischen dem Ausgangssignal des 1Bit-AD-Wandlers 10 und dem entsprechenden Signal im Vorwärtspfad zugeführt wird. Die zweite Wandlerstufe 2 empfängt über einen Addierer 16 als Eingangssignal das Differenzsignal zwischen dem analogen Ausgangssignal des 1Bit-DA-Wandlers 11 und dem Eingangssignal des 1Bit-AD-Wandlers 10, d.h. der zweiten Wandlerstufe 2 wird der durch die 1Bit-Quantisierung hervorgerufene Quantisierungsfehler zugeführt. Der Aufbau der zweiten Wandlerstufe 2 entspricht einem einstufigen 3Bit-Sigma-Delta-Wandler und umfaßt demzufolge einen Addierer 18, einen Integrator 20, einen 3Bit-AD-Wandler 21 und einen 3Bit-DA-Wandler 22, die gemäß Fig. 5 verschaltet sind. Die von den beiden Wandlerstufen 1, 2 gelieferten Ausgangssignale werden von einer Rauschunterdrückungslogik 3 digital verarbeitet, so daß ein dem analogen Eingangssignal X(z) entsprechendes digitales Ausgangssignal Y(z) ausgegeben wird. Die Integratoren 6, 9 und 20 können jeweils durch SC-Filter gebildet und beispielsweise durch die Übertragungsfunktion 1/(1-z⁻¹) bzw. z⁻¹/(1-z⁻¹) dargestellt werden.

Bei der in Fig. 5 gezeigten Schaltung wird die hohe Empfindlichkeit bezüglich der Genauigkeit der im Rückkopplungszweig angeordneten DA-Wandler, welche die Linearität und Auflösung der Sigma-Delta-Wandlerarchitektur beschränkt, dadurch verringert, daß lediglich in der zweiten Wandlerstufe 2 ein Multibit-Quantisierer verwendet wird, während der kritischere Quantisierer der ersten Wandlerstufe 1 als Einbit-Quantisierer ausgestaltet ist.

In der Druckschrift "A Cascaded Sigma-Delta Pipeline A/D Converter with 1.25 MHz Signal Bandwidth and 89dB SNR", T.L. Brooks, D.H. Robertson, D.F. Kelly. A. Del Muro, S.W. Harston, IEEE Journal of Solid-State Circuits, vol. 32, Seiten 1896-1906, Dezember 1997, wird eine Abwandlung dieser kaskadenartigen Sigma-Delta-Wandlerarchitektur dahingehend vorgeschlagen, daß eine Sigma-Delta-Wandlerstufe kaskadenartig mit einer Pipeline-AD-Wandlerstruktur verschaltet wird. Die Sigma-Delta-Wandlerstufe entspricht insbesondere einem Sigma-Delta-Wandler zweiter Ordnung mit 5Bit-Quantisierung, während die Pipeline-AD-Wandlerstruktur vierstufig ausgestaltet ist. Die niederwertigeren Bits des Ausgangssignals der Pipeline-AD-Wandlerstruktur werden als Schätzung für den Quantisierungsfehler des 5Bit-Quantisierers der Sigma-Delta-Wandlerstufe verwendet und mit dem zeitverzögerten Ausgangssignal der Sigma-Delta-Wandlerstufe derart kombiniert, daß ein digitales Ausgangssignal erhalten wird, welches dem Ausgangssignal eines Sigma-Delta-Wandlers zweiter Ordnung mit 12Bit-Quantisierung entspricht. Diese Architektur besitzt jedoch den Nachteil, daß die zweite Stufe in Form eines Pipeline-AD-Wandlers ausgestaltet sein muß, so daß die Implementierung einer Wandlerarchitektur dritter Ordnung oder höher zu einer verringerten Systemstabilität führen würde. Diese Sigma-Delta-Wandlerarchitektur entspricht einer Erweiterung der von T.C. Leslie und B. Singh vorgeschlagenen Architektur.

Der vorliegenden Erfindung liegt die Aufgabe zugrunde, eine neuartige Sigma-Delta-Wandleranordnung zu schaffen, die einen hervorragenden Kompromiß zwischen der von der Schaltung benötigten wirksamen Siliziumfläche einerseits und dem Energieverbrauch andererseits darstellt.

Diese Aufgabe wird gemäß der vorliegenden Erfindung durch eine Sigma-Delta-Wandleranordnung mit den Merkmalen des Anspruches 1 gelöst. Die Unteransprüche definieren vorteilhafte und bevorzugte Ausführungsformen der vorliegenden Erfindung.

Die erfindungsgemäße Sigma-Delta-Wandleranordnung ist mehrstufig, insbesondere zweistufig, aufgebaut und verwendet sowohl in der ersten Sigma-Delta-Wandlerstufe als auch in der zweiten Sigma-Delta-Wandlerstufe eine Multibit-Quantisierung. Die Verwendung einer Multibit-Quantisierung auch in der ersten Sigma-Delta-Wandlerstufe war bisher bei Sigma-Delta-Wandlerarchitekturen mit zwei oder mehr kaskadenartig verschalteten Sigma-Delta-Wandlerstufen nicht bekannt.

Die gesamte Sigma-Delta-Wandleranordnung kann somit auch in Form von Sigma-Delta-Modulatoren dritter oder höherer Ordnung realisiert werden, ohne die Systemstabilität zu beeinflussen, wobei weiterhin eine flächenwirksame Implementierung mit geringem Strom- oder Energieverbrauch möglich ist.

Darüber hinaus kann durch die Verwendung eines mehrstufigen Sigma-Delta-Wandlers die gewünschte Quantisierungsauflösung auf die einzelnen Multibit-Wandlerstufen aufgeteilt werden. Die von der gesamten Sigma-Delta-Wandlerarchitektur realisierte Quantisierungsauflösung berechnet sich durch (Quantisierungsbreite der ersten Stufe + Quantisierungsbreite der zweiten Stufe) - 1.

Die Auflösung der ersten Wandlerstufe und die Auflösung der zweiten Wandlerstufe gehen jeweils in das Ausgangssignal der Sigma-Delta-Wandleranordnung ein, so daß eine Sigma-Delta-Wandleranordnung beliebiger Ordnung als Kompromiß zwischen dem Energieverbrauch einerseits und der benötigten Siliziumfläche andererseits optimiert werden kann. Die Erfindung ist insbesondere für Anwendungen, die einen geringen Stromverbrauch und eine hohe Auflösung erfordern, von Vorteil und kann daher beispielsweise in BQAP-, ISDN-, ADSL-, HDSL- oder allgemein xDSL-Anwendungen sowie u.a. in schnurlosen Telefonen eingesetzt werden.

Durch den Ersatz der bekannten Einbit-Quantisierung der ersten Sigma-Delta-Wandlerstufe durch eine Mutibit-Quantisierung wird eine verbesserte Auflösung und eine geringere Leckempfindlichkeit erreicht. Darüber hinaus wird die Anzahl der Parameter, die zur Optimierung einer Multibit-Sigma-Delta-Wandlerarchitektur verwendet werden können, erhöht. Die erfindungsgemäße Multibit-Sigma-Delta-Wandlerarchitektur gewährleistet eine hohe Leistungsfähigkeit auch ohne Verwendung von DEM-Techniken (Dynamic Element Matching) oder anderer Techniken zur Verbesserung der internen DA-Wandlerleistung.

Die erfindungsgemäße Architektur ist vorteilhafterweise derart ausgestaltet, daß ein digitales Ausgangssignal erhalten wird, welches dem Ausgangssignal eines 7Bit-Sigma-Delta-Wandlers dritter Ordnung entspricht. Die erste Sigma-Delta-Wandlerstufe kann zu diesem Zweck insbesondere durch einen 3Bit-Sigma-Delta-Wandler zweiter Ordnung gebildet sein, während die zweite Sigma-Delta-Wandlerstufe vorteilhafterweise einem 5Bit-Sigma-Delta-Wandler erster Ordnung entsprechen kann.

Die Erfindung wird nachfolgend unter Bezugnahme auf die beigefügte Zeichnung anhand eines bevorzugten Ausführungsbeispiels erläutert.
Fig. 1 zeigt ein Blockschaltbild eines bevorzugten Ausführungsbeispiels einer erfindungsgemäßen Sigma-Delta-Analog/Digital-Wandleranordnung,
Fig. 2 zeigt eine Tabelle, welche die in Fig. 1 gezeigte Architektur mit weiteren bekannten Architekturen vergleicht,
Fig. 3 zeigt den Verlauf des gemessenen Ausgangsspektrums der in Fig. 1 gezeigten Architektur,
Fig. 4 zeigt Signalverläufe zur Verdeutlichung der Leistungsfähigkeit der in Fig. 1 gezeigten Architektur, und
Fig. 5 zeigt eine bekannte Sigma-Delta-Analog/Digital-Wandleranordnung gemäß dem Stand der Technik.

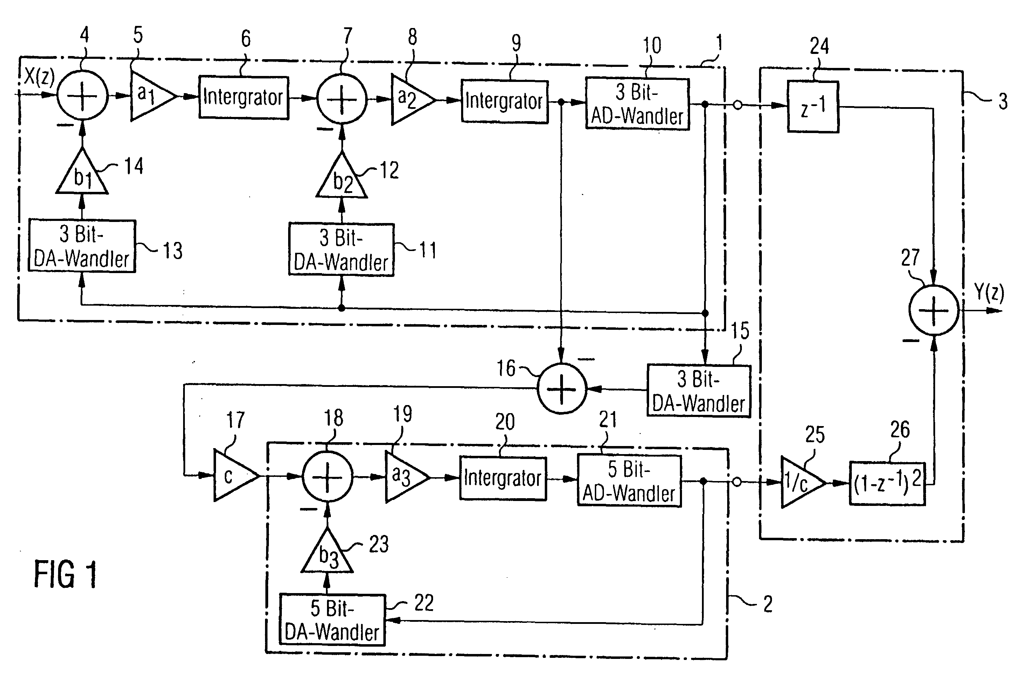

Bei der in Fig. 1 gezeigten Sigma-Delta-Analog/Digital-Wandleranordnung handelt es sich um eine für den Betrieb mit niedrigen Überabtastraten ausgelegte hochauflösende Sigma-Delta-Analog/Digital-Wandlerarchitektur, die insbesondere beispielsweise mit einer Abtastrate von 26MHz getaktet und durch einen 0,6µm-Standard-CMOS-Prozeß hergestellt werden kann. Wie nachfolgend noch näher erläutert wird, kann mit Hilfe dieser Sigma-Delta-Analog/Digital-Wandleranordnung bei einer Signabandbreite von 1,1MHz ein Signalrauschabstand von 86dB erzielt werden.

Für xDSL-Anwendungen sind billige Hochleistungswandler mit geringem Energiebedarf erforderlich. Des weiteren wird für eine analoge Signalbandbreite von 1,1MHz beispielsweise eine 14Bit-Auflösung gefordert. Mit Hilfe der eingangs beschriebenen Pipeline-Analog/Digital-Wandler kann zwar eine große Signalbandbreite erzielt werden, der Dynamikbereich ist jedoch beschränkt. Daher wird bei der in Fig. 1 gezeigten Architektur ein kaskadierter Sigma-Delta-Wandler verwendet, der eine kaskadenartige Verschaltung zweier Sigma-Delta-Wandlerstufen umfaßt. Durch die Verwendung eines mehrstufigen Sigma-Delta-Wandlers kann die gewünschte Quantisierungsauflösung auf die einzelnen Wandlerstufen aufgeteilt werden.

Der vorliegende Sigma-Delta-Wandler wird vorzugsweise mit einer relativ geringen Überabtastrate (Oversampling Rate, OSR) betrieben (beispielsweise OSR = 12), um die Abtastrate und demzufolge den Energieverbrauch möglichst gering zu halten. Um die oben erwähnte gewünschte Auflösung realisieren zu können, kann in diesem Fall ein Sigma-Delta-Wandler zweiter oder dritter Ordnung verwendet werden. Ein Sigma-Delta-Wandler zweiter Ordung benötigt für die gewünschte Auflösung eine interne 9Bit-Quantisierung, während für einen Sigma-Delta-Wandler dritter Ordnung hierzu eine interne 7Bit-Quantisierung ausreichend ist. Sigma-Delta-Wandler höherer Ordnung führen bei derart niedrigen Überabtastungsverhältnisses zu keiner weiteren Verbesserung.

Die Auflösung der internen Quantisierung bestimmt wesentlich die von der gesamten Architektur benötigte Siliziumfläche. Da bei Verwendung eines Sigma-Delta-Wandlers dritter Ordnung eine geringere Bitbreite für die Quantisierung erforderlich ist, wurde diese Ausgestaltung für das in Fig. 1 gezeigte Ausführungsbeispiel gewählt.

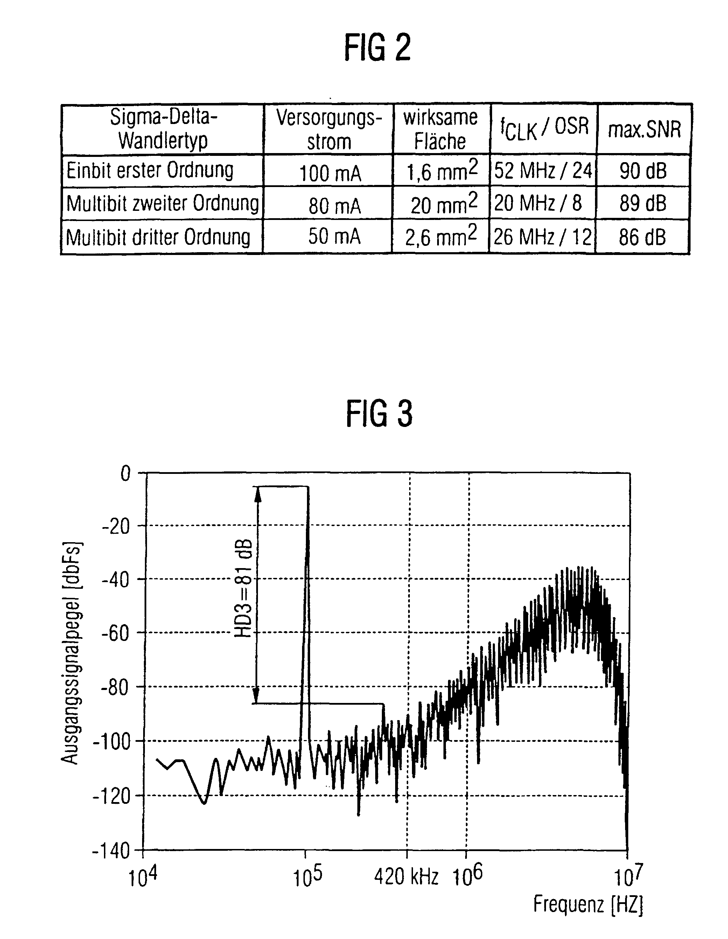

In Fig. 2 ist für ähnliche Auflösungen und ähnliche Signalbandbreiten ein Vergleich verschiedener Sigma-Delta-Wandlertypen hinsichtlich des Versorgungsstroms, der jeweils wirksamen Siliziumfläche, der Abtastfrequenz f_{CLK}, der Überabtastrate OSR und dem jeweils erzielbaren Signalrauschabstand SNR dargestellt. Der in der ersten Zeile von Fig. 2 aufgeführte Einbit-Sigma-Delta-Wandler entspricht der von T.C. Leslie und B. Singh vorgeschlagenen Architektur, während der in der zweiten Zeile von Fig. 2 dargestellte Sigma-Delta-Wandler der von T.L. Brooks, D.H. Robertson, D.F. Kelly. A. Del Muro und S.W. Harston vorgeschlagenen Architektur entspricht. In der letzten Zeile von Fig. 2 ist ein Multibit-Sigma-Delta-Wandler gemäß der vorliegenden Erfindung aufgeführt. Der in Fig. 2 gezeigten Tabelle kann entnommen werden, daß bei Verwendung von Multibit-Sigma-Delta-Wandlern deutlich der Flächenbedarf steigt, während andererseits die Verwendung von Einbit-Sigma-Delta-Wandlern höhere Abtastfrequenzen erfordert und somit einen höheren Energieverbrauch zur Folge hat.

Der in Fig. 1 gezeigte Sigma-Delta-Wandler umfaßt im wesentlichen zwei Sigma-Delta-Wandlerstufen 1, 2, deren digitalen Ausgangssignale über eine digitale Rauschunterdrückungslogik 3 kombiniert und verarbeitet werden. Die erste Sigma-Delta-Wandlerstufe 1 entspricht einem Sigma-Delta-Wandler bzw. einem Sigma-Delta-Modulator zweiter Ordnung mit einer 3Bit-Quantisierung und empfängt ein zu digitalisierendes Eingangssignal X(z). Die erste Sigma-Delta-Wandlerstufe 1 umfaßt somit gemäß Fig. 1 verschaltete Integratoren 6, 9, Addierer 4, 7, einen 3Bit-AD-Wandler 10 und in den Rückkopplungszweigen angeordnete 3Bit-DA-Wandler 11, 13. Diejenigen Bauteile, welche den in Fig. 5 gezeigten Bauteilen entsprechen, sind mit denselben Bezugszeichen versehen, so daß ergänzend auf die Beschreibung zu Fig. 5 verwiesen werden kann. Zwischen den einzelnen Bauteilen sind Puffer bzw. Verstärker 5, 8, 12 und 14 mit den Verstärkungsfaktoren a₁, a₂, b₂ bzw. b₁ angeordnet.

Die zweite Sigma-Delta-Wandlerstufe 2 entspricht einem 5Bit-Sigma-Delta-Wandler erster Ordnung und umfaßt einen Addierer 18, einen Integrator 20, einen 5Bit-AD-Wandler 21, einen 5Bit-DA-Wandler 22 sowie Verstärker 19 und 23 mit Verstärkungsfaktoren a₃ bzw. b₃. Wie Fig. 1 entnommen werden kann, wird der zweiten Sigma-Delta-Wandlerstufe 2 über einen weiteren 3Bit-DA-Wandler 15 und einen Addierer 16 sowie einen Verstärker 17 mit dem Verstärkungsfaktor c der Quantisierungsfehler der ersten Sigma-Delta-Wandlerstufe 1 zugeführt. Die in Fig. 1 gezeigten drei 3Bit-DA-Wandler 11, 13 und 15 können selbstverstädnlich bei entsprechender Schaltungsabwandlung auch gemäß Fig. 7 durch einen einzigen im Rückkopplungszweig der ersten Sigma-Delta-Wandlerstufe 1 angeordneten 3Bit-DA-Wandler ersetzt werden.

Wie bereits erwähnt worden ist, sind die von den beiden Sigma-Delta-Wandlerstufen 1, 2 erzeugten digitalen Ausgangssignale einer Rauschunterdrückungslogik 3 zugeführt. Die Rauschunterdrückungslogik 3 bewertet mit Hilfe eines Verstärkers 25 das Ausgangssignal der zweiten Sigma-Delta-Wandlerstufe 2 mit dem inversen Kopplungsverstärkungsfaktor des Verstärkers 17 und unterzieht das somit bewertete digitale Ausgangssignal einer digitalen Filterung, wobei das hierfür verwendete digitale Filter 26 beispielsweise die Übertragungsfunktion (1-z⁻¹)² aufweist. Das gefilterte und mit 1/c bewertete Ausgangssignal der zweiten Sigma-Delta-Wandlerstufe 2 wird von dem mit Hilfe eines Verzögerungsglieds 24 zeitlich verzögerten Ausgangssignal der ersten Sigma-Delta-Wandlerstufe 1 subtrahiert (Addierer 27), um den Quantisierungsfehler der ersten Sigma-Delta-Wandlerstufe 1 zu eliminieren, so daß schließlich das gewünschte digitale Ausgangssignal Y(z) ausgegeben wird, welches dem Ausgangssignal eines Sigma-Delta-Wandlers dritter Ordnung mit interner 7Bit-Quantisierung entspricht.

Hinsichtlich mehrstufiger Sigma-Delta-Wandlern ist bekannt, daß Leckrauschen einen kritischen und die Leistungsfähigkeit begrenzenden Faktor darstellt. Unter Leckrauschen wird das Quantisierungsrauschen des Quantisierers der ersten Sigma-Delta-Wandlerstufe 1 verstanden, welches nicht vollständig von der Rauschunterdrückungslogik 3 eliminiert werden konnte. Die Leistung der Leckrauschkomponente im Ausgangssignal Y(z) hängt im wesentlichen von zwei Faktoren, nämlich der Fehlanpassung zwischen der analogen Rauschübertragungsfunktion (Noise Transfer Function, NTF) der ersten Wandlerstufe 1 und der NTF der Rauschunterdrückungslogik 3 sowie der Leistung des Quantisierungsfehlers der ersten Wandlerstufe 1, ab. Die NTF-Fehlanpassung hängt stark von der Qualität der verwendeten analogen Bauteile ab, während die Leistung des Quantisierungsrauschens der ersten Wandlerstufe 1 umgekehrt proportional zu dem quadratischen Wert der Auflösung des Quantisierers ist. Hinsichtlich dieses Aspekts ist daher eine möglichst hohe Quantisierungsauflösung der ersten Wandlerstufe wünschenswert. Durch die Verwendung einer 3Bit-Quantisierung in der ersten Wandlerstufe 1 kann bei üblicher Fehlanpassung der NTFs in dem hier interessierenden Frequenzband ein Leckrauscheffektivwert erhalten werden, der ca. 100dB geringer als der Effektivwert eines Sinussignals maximaler Amplitude ist.

Wie bereits erwähnt worden ist, weisen Multibit-Sigma-Delta-Wandler den Nachteil auf, daß sie sehr empfindlich gegenüber Ungenauigkeiten der internen DA-Wandler sind. Durch Verwendung von sogenannten DEM-Techniken (Dynamic Element Matching) können zwar diese Ungenauigkeiten in einem gewissen Bereich verringert werden. Die DEM-Techniken rufen jedoch in dem Rückkopplungszweig des entsprechenden Sigma-Delta-Wandlers zusätzliche Verzögerungen hervor.

Bei der in Fig. 1 gezeigten Architektur kann die Verwendung derartiger DEM-Techniken vermieden werden, da durch einfache schaltungstechnische Maßnahmen eine ausreichend gute Anpassung der einzelnen Elemente erzielt werden kann. Simulationen haben gezeigt, daß eine Standardabweichung der Elemente des 3Bit-DA-Wandlers < 0,05% ausreicht, um den Signalrauschabstand harmonische Störungen unterhalb von -100dB zu drücken. Die 3Bit-DA-Wandler werden vorzugsweise gemäß der sogenannten Switched Capacitor-Technik (SC-Technik) implementiert, wobei hierzu sieben Einheitskondensatoren verwendet werden. Die SC-Technik ist beispielsweise ausführlich in den bereits eingangs beschriebenen Druckschriften "A 50MHz Multibit Sigma-Delta Modulator for 12b 2MHZ A/D Conversion", B.P. Brandt, B.A. Wolley, IEEE Journal of Solid-State Circuits, vol. 26, Dezember 1991, und "A Cascaded Sigma-Delta Pipeline A/D Converter with 1.25 MHz Signal Bandwidth and 89dB SNR", T.L. Brooks, D.H. Robertson, D.F. Kelly. A. Del Muro, S.W. Harston, IEEE Journal of Solid-State Circuits, vol. 32, Seiten 1896-1906, Dezember 1997, erläutert, so daß ergänzend auf die Ausführungen in diesen Druckschriften verwiesen wird. Der Absolutwert der verwendeten Kondensatoren bestimmt die Anpassungseigenschaften sowie das hervorgerufene thermische Rauschen. Es hat sich herausgestellt, daß hinsichtlich des thermischen Rauschens größere Kondensatoren erforderlich sind, als dies hinsichtlich der Elementenanpassung für den bevorzugt verwendeten 0,6µm-Standard-CMOS-Prozeß erforderlich wäre. Allgemein erfordern Sigma-Delta-Wandler, die mit einer niedrigen Überabtastung betrieben werden, in der Eingangsstufe größere Kondensatoren. Somit wird auch eine gute Anpassung erzielt, ohne daß die Verwendung von DEM-Techniken erforderlich wäre.

Sämtliche analogen Elemente der Sigma-Delta-Wandler sind vorteilhafterweise vollständig differentiell gemäß der SC-Technik implementiert. Für die Eingangswandlerstufe 1 kann vorzugweise eine nicht-kanonische Struktur gewählt werden, wodurch zwar die Gesamtkapazität verdoppelt wird, andererseits jedoch eine Signalunabhängigkeit der von der internen Referenzspannungsquelle gezogenen Ladung erzielt werden kann. Dies ist insbesondere deshalb vorteilhaft, da die interne Referenzspannungsquelle eine äußerst empfindliche Komponente des Sigma-Delta-Wandlers darstellt. In der Regel werden die zuvor erwähnten und in Fig. 1 gezeigten Verstärkungsfaktoren b₁ und b₃ zu 1 gewählt. Der Verstärkungsfaktor b₁ kann jedoch beispielsweise auch zur Skalierung des Eingangsbereichs des Sigma-Delta-Wandlers ≠1 gewählt werden, wofür die nicht-kanonische Struktur erforderlich ist. Für die weniger kritische zweite Sigma-Delta-Wandlerstufe 2 wird vorzugsweise eine kanonische SC-Struktur verwendet, wie sie auch in der bereits erwähnten Druckschrift "A Cascaded Sigma-Delta Pipeline A/D Converter with 1.25 MHz Signal Bandwidth and 89dB SNR", T.L. Brooks, D.H. Robertson, D.F. Kelly. A. Del Muro, S.W. Harston, IEEE Journal of Solid-State Circuits, vol. 32, Seiten 1896-1906, Dezember 1997, erläutert ist.

Für alle SC-Integratoren 6, 9 und 20 wird vorzugsweise derselbe Transkonduktanzverstärker mit einer Übergangsfrequenz von 150MHz und einer Gleichstromverstärkung von 80dB verwendet. Auch die einzelnen Flash-AD-Wandler 10 und 21 sind vorzugsweise vollständig differentiell gemäß der SC-Technik implementiert, wobei ein einstufiger Komparator verwendet werden kann.

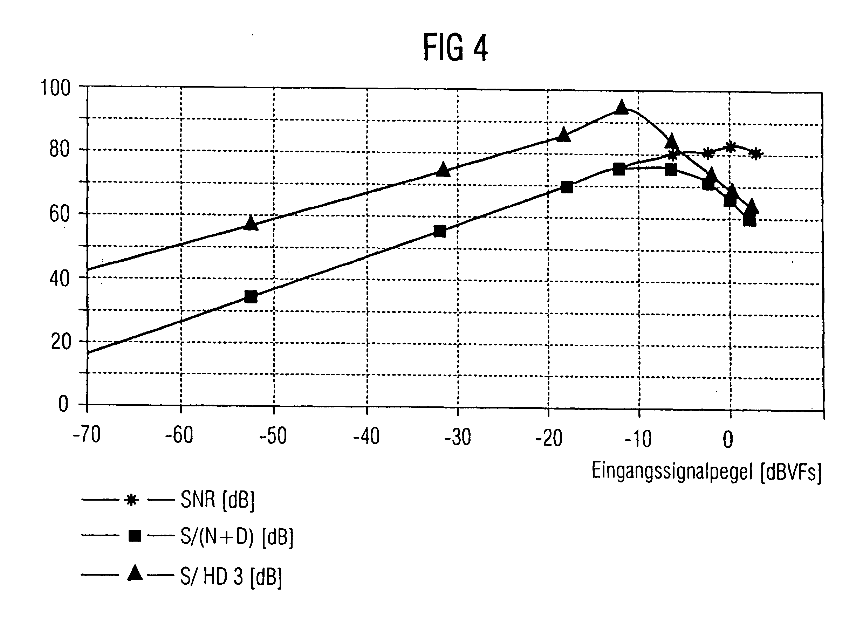

In Fig. 3 und Fig. 4 sind Meßergebnisse für den in Fig. 1 gezeigten Sigma-Delta-Analog/Digital-Wandler bei einer Abtastfrequenz von 10MHz und für eine Eingangssignalfrequenz von 100kHz dargestellt.

In Fig. 3 ist das logarithmisch aufgetragene Ausgangsspektrum für ein sinusförmiges Eingangssignal mit einer Amplitude von 2Vpp (-6dB) dargestellt. Bei niedrigen Frequenzen ist weißes Rauschen dominant. Bei höheren Frequenzen, insbesondere oberhalb der senkrecht eingezeichneten Linie bei 420kHz, die bei einer 12fachen Überabtastung (OSR = 12) dem im vorliegenden Fall interessierende Frequenzband entspricht, wird das Quantisierungsrauschen dominant. Die harmonische Verzerrung dritter Ordnung (HD3) beträgt -81dB.

In Fig. 4 sind für unterschiedliche Eingangssignalamplituden der Signalrauschabstand (SNR), das Verhältnis des Signalpegels zum Rausch- und Verzerrungspegel (S/(N+D)) sowie das Verhältnis des Signalpegels zum Pegel der harmonischen Verzerrung dritter Ordnung (S/HD3) dargestellt. Der Wert S/HD3 erreicht bei einem Eingangssignalpegel von -12dB seinen Maximalwert von 94dB, während der Wert SNR seinen Maximalwert von 83dB bei einem Eingangssignalpegel von 0dB erreicht.

Die beiden in Fig. 1 gezeigten Sigma-Delta-Wandlerstufen 1, 2 werden vorzugsweise zusammen mit einem zusätzlichen aktiven Anti-Aliasing-Filter, der als Vorfilter zum Betreiben des Sigma-Delta-Wandlers dient, sowie den für die SC-Implementierung benötigten Referenzspannungsquellen auf einem Chip angeordnet, während die Rauschunterdrückungslogik 3 auch davon getrennt extern vorgesehen sein kann.

## Patentansprüche

1. Sigma-Delta-Analog/Digital-Wandleranordnung,
mit mindestens zwei Sigma-Delta-Wandlerstufen (1, 2), die jeweils einen im Vorwärtspfad der entsprechenden Sigma-Delta-Wandlerstufe angeordneten Multibit-Analog/Digital-Wandler (10, 21) und einen im Rückkopplungspfad angeordneten Multibit-Digital/Analog-Wandler (11, 13, 22) umfassen,
wobei die beiden Sigma-Delta-Wandlerstufen (1, 2) kaskadenartig derart verschaltet sind, daß der ersten Sigma-Delta-Wandlerstufe (1) ein in ein digitales Ausgabesignal (Y(z)) umzuwandelndes analoges Eingabesignal (X(z)) zugeführt ist, während der zweiten Sigma-Delta-Wandlerstufe (2) das analoge Differenzsignal zwischen dem mit Hilfe eines ersten Multibit-Digital/Analog-Wandlers (15) digital/analoggewandelten Ausgangssignal des Multibit-Analog/Digital-Wandlers (10) der ersten Sigma-Delta-Wandlerstufe (10) und dem Eingangssignal des Multibit-Analog/Digital-Wandlers (10) der ersten Sigma-Delta-Wandlerstufe (1) zugeführt ist,
wobei das dem analogen Eingabesignal (X(z)) entsprechende digitale Ausgabesignal (Y(z)) durch Kombination der Ausgangssignale der digitalen Multibit-Analog/Digital-Wandler (10, 21) der beiden Sigma-Delta-Wandlerstufen (1, 2) gewinnbar ist,
**dadurch gekennzeichnet,**
**daß** die Sigma-Delta-Analog/Digital-Wandleranordnung entsprechend einem Sigma-Delta-Analog/Digital-Wandler dritter Ordnung aufgebaut ist,
**daß** die erste Sigma-Delta-Wandlerstufe (1) einem Sigma-Delta-Analog/Digital-Wandler zweiter Ordnung entspricht,
**daß** die zweite Sigma-Delta-Wandlerstufe (2) einem Sigma-Delta-Analog/Digital-Wandler erster Ordnung entspricht, und dass im Vorwärtspfad der ersten Sigma-Delta-Wandlerstufe (1) ein erster Integrator (6) und ein zweiter Integrator (9) angeordnet sind, wobei dem ersten Integrator (6) das analoge Differenzsignal zwischen dem analogen Eingabesignal (X(z)) und dem mit Hilfe eines zweiten Multibit-Digital/Analog-Wandlers (13) digital/analog-gewandelten Ausgangssignal des Multibit-Analog/Digital-Wandlers (10) der ersten Sigma-Delta-Wandlerstufe (10) zugeführt ist, während dem zweiten Integrator (9) das analoge Differenzsignal zwischen dem Ausgangssignal des ersten Integrators (6) und dem mit Hilfe eines dritten Multibit-Digital/Analog-Wandlers (11) digital/analog-gewandelten Ausgangssignal des Multibit-Analog/Digital-Wandlers (10) der ersten Sigma-Delta-Wandlerstufe (10) zugeführt ist, wobei das Ausgangssignal des zweiten Integrators (9) dem Multibit-Analog/Digital-Wandler (10) der ersten Sigma-Delta-Wandlerstufe (1) zugeführt ist.

2. Sigma-Delta-Analog/Digital-Wandleranordnung nach einem der vorhergehenden Ansprüche,
**dadurch gekennzeichnet,**
**daß** die Bitbreite der Multibit-Analog/Digital-Wandler (10, 21) und Multibit-Digital/Analog-Wandler (11, 13, 15, 22) der beiden Sigma-Delta-Wandlerstufen (1, 2) derart gewählt ist, daß das durch Kombination der digitalen Ausgangssignale der beiden Sigma-Delta-Wandlerstufen (1, 2) gewinnbare digitale Ausgabesignal (Y(z)) dem digitalen Ausgabesignal eines Sigma-Delta-Wandlers mit 7Bit-Quantisierung entspricht.

3. Sigma-Delta-Analog/Digital-Wandleranordnung nach einem der vorhergehenden Ansprüche,
**dadurch gekennzeichnet,**
**daß** der Multibit-Analog/Digital-Wandler (21) der zweiten Sigma-Delta-Wandlerstufe (2) ein 5Bit-Analog/Digital-Wandler und der Multibit-Digital/Analog-Wandler (22) der zweiten Sigma-Delta-Wandlerstufe (2) ein 5Bit-Digital/Analog-Wandler ist.

4. Sigma-Delta-Analog/Digital-Wandleranordnung nach einem der vorhergehenden Ansprüche,
**dadurch gekennzeichnet,**
**daß** der Multibit-Analog/Digital-Wandler (10) der ersten Sigma-Delta-Wandlerstufe (1) ein 3Bit-Analog/Digital-Wandler und die Multibit-Digital/Analog-Wandler (11, 13, 15) der ersten Sigma-Delta-Wandlerstufe (1) 3Bit-Digital/Analog-Wandler sind.

5. Sigma-Delta-Analog/Digital-Wandleranordnung nach einem der vorhergehenden Ansprüche,
**dadurch gekennzeichnet,**
**daß** die digitalen Ausgangssignale der beiden Sigma-Delta-Wandlerstufen (1, 2) einer Rauschunterdrückungsschaltung (3) zugeführt sind, welche durch Kombination der digitalen Ausgabesignale der beiden Sigma-Delta-Wandlerstufen (1, 2) das digitale Ausgabesignal (Y(z)) ermittelt und ausgibt.

6. Sigma-Delta-Analog/Digital-Wandleranordnung nach Anspruch 5,
**dadurch gekennzeichnet,**
**daß** die beiden Sigma-Delta-Wandlerstufen (1, 2) auf einem gemäß einem 0,6µm-CMOS-Prozeß hergestellten Chip angeordnet sind.

7. Sigma-Delta-Analog/Digital-Wandleranordnung nach Anspruch 5 oder 6,
**dadurch gekennzeichnet,**
**daß** die Rauschunterdrückungsschaltung (3) eine Verzögerungsschaltung (24) und eine digitale Filterschaltung (26) umfaßt,
wobei das digitale Ausgangssignal der ersten Sigma-Delta-Wandlerstufe (1) der Verzögerungsschaltung (24) zugeführt ist,
wobei das digitale Ausgangssignal der zweiten Sigma-Delta-Wandlerstufe (1) der digitalen Filterschaltung (26) zugeführt ist, und
wobei die Rauschunterdrückungsschaltung (3) die Differenz zwischen dem Ausgangssignal der Verzögerungsschaltung (24) und dem Ausgangssignal der digitalen Filterschaltung (26) als das digitale Ausgabesignal (Y(z)) ausgibt.

8. Sigma-Delta-Analog/Digital-Wandleranordnung nach einem der vorhergehenden Ansprüche,
**dadurch gekennzeichnet,**
**daß** die Multibit-Analog/Digital-Wandler (10, 21) der beiden Sigma-Delta-Wandlerstufen (1, 2) durch Flash-Wandler gebildet sind.

9. Sigma-Delta-Analog/Digital-Wandleranordnung nach einem der vorhergehenden Ansprüche,
**dadurch gekennzeichnet,**
**daß** die beiden Sigma-Delta-Wandlerstufen (1, 2) durch Switched Capacitor-Technik realisiert sind.

10. Sigma-Delta-Analog/Digital-Wandleranordnung nach Anspruch 9,
**dadurch gekennzeichnet,**
**daß** die erste Sigma-Delta-Wandlerstufe (1) durch eine nicht-kanonische Switched Capacitor-Struktur gebildet ist, und daß die zweite Sigma-Delta-Wandlerstufe (2) durch eine kanonische Switched Capacitor-Struktur gebildet ist,

## Claims

1. Sigma-delta analogue-to-digital converter array, comprising at least two sigma-delta converter stages (1, 2) each comprising a multi-bit analogue-to-digital converter (10, 21) arranged in the forward path of the corresponding sigma-delta converter stage and a multi-bit digital-to-analogue converter (11, 13, 22) arranged in the feedback path, the two sigma-delta converter stages (1, 2) being connected in a cascaded array such that an analogue input signal (X(z)) to be converted into a digital output signal (Y(z)) is supplied to the first sigma-delta converter stage (1), while the analogue differential signal between the digital-to-analogue output signal, converted with the aid of a first multi-bit digital-to-analogue converter (15), of the multi-bit analogue-to-digital converter (10) of the first sigma-delta converter stage (10) and the input signal of the multi-bit analogue-to-digital converter (10) of the first sigma-delta converter stage (1) stage is supplied to the second sigma-delta converter stage (2), the digital output signal (Y(z)) corresponding to the analogue input signal (X(z)), being obtained by combining the output signals of the digital multi-bit analogue-to-digital converters (10, 21) of the two sigma-delta converter stages, (1, 2), **characterised in that** the sigma-delta analogue-to-digital converter array is configured to correspond to a third order sigma-delta analogue-to-digital converter, **in that** the first sigma-delta converter stage (1) corresponds to a second order sigma-delta analogue-to-digital converter, **in that** the second sigma-delta converter stage (2) corresponds to a first order sigma-delta analogue-to-digital converter, and **in that** a first integrator (6) and a second integrator (9) are arranged in the forward path of the first sigma-delta converter stage (1), the analogue differential signal between the analogue input signal (X(z)) and the digital-to-analogue output signal, converted with the aid of a second multi-bit digital-to-analogue converter (13), of the multi-bit analogue-to-digital converter (10) of the first sigma-delta converter stage (10) being supplied to the first integrator (6), while the analogue differential signal between the output signal of the first integrator (6) and the digital-to-analogue output signal, converted with the aid of a third multi-bit digital-to-analogue converter (11), of the multi-bit analogue-to-digital converter (10) of the first sigma-delta converter stage (10) being supplied to the second integrator (9), the output signal of the second integrator (9) being supplied to the multi-bit analogue-to-digital converter (10) of the first sigma-delta converter stage (1).

2. Sigma-delta analogue-to-digital converter array according to any one of the preceding claims, **characterised in that** the bit width of the multi-bit analogue-to-digital converter (10, 21) and multi-bit digital-to-analogue converters (11, 13, 15, 22) of the two sigma-delta converter stages (1, 2) are selected such that the digital output signal (Y(z)) obtained by combining the digital output signals of the two sigma-delta converter stages (1, 2) corresponds to the digital output signal of a sigma-delta converter with 7-bit quantisation.

3. Sigma-delta analogue-to-digital converter array according to either of the preceding claims, **characterised in that** the multi-bit analogue-to-digital converter (21) of the second sigma-delta converter stage (2) is a 5-bit analogue-to-digital converter and the multi-bit digital-to-analogue converter (22) of the second sigma-delta converter stage (2) is a 5-bit digital-to-analogue converter.

4. Sigma-delta analogue-to-digital converter array according to any one of the preceding claims, **characterised in that** the multi-bit analogue-to-digital converter (10) of the first sigma-delta converter stage (1) is a 3-bit analogue-to-digital converter and the multi-bit digital-to-analogue converter (11, 13, 15) of the first sigma-delta converter stage (1) is a 3-bit digital-to-analogue converter.

5. Sigma-delta analogue-to-digital converter array according to any one of the preceding claims, **characterised in that** the digital output signals of the two sigma-delta converter stages (1, 2) are supplied to a noise suppression circuit (3) that determines and outputs the digital output signal (Y(z)) by combining the digital output signals of the two sigma-delta converter stages (1, 2).

6. Sigma-delta analogue-to-digital converter array according to claim 5, **characterised in that** the two sigma-delta converter stages (1, 2) are arranged on a chip constructed according to a 0.6 µm-CMOS process.

7. Sigma-delta analogue-to-digital converter array according to either claim 5 or claim 6, **characterised in that** the noise suppression circuit (3) includes a delay circuit (24), and a digital filter circuit (26), the digital output signal of the first sigma-delta converter stage (1) being supplied to the delay circuit (24), and the digital output signal of the second sigma-delta converter stage (1) being supplied to the digital filter circuit (26), the noise suppression circuit (3) outputting the difference between the output signal of the delay circuit (24) and the output signal of the digital filter circuit (26) as the digital output signal (Y(z)).

8. Sigma-delta analogue-to-digital converter array according to any one of the preceding claims, **characterised in that** the multi-bit analogue-to-digital converter (10, 21) of the two sigma-delta converter stages (1, 2) is a flash converter.

9. Sigma-delta analogue-to-digital converter array according to any one of the preceding claims, **characterised in that** the two sigma-delta converter stages (1, 2) are operated using a switched capacitor technique.

10. Sigma-delta analogue-to-digital converter array according to claim 9, **characterised in that** the first sigma-delta converter stage (1) is configured as a non-canonical switched-capacitor. structure and the second sigma-delta converter stage (2) is configured as a canonical switched-capacitor structure.

## Revendications

1. Ensemble convertisseur sigma-delta analogique /numérique, avec au moins deux étages de convertisseur sigma-delta (1, 2) qui comprennent chacun un convertisseur analogique/numérique multibit (10, 21) placé dans la voie d'aller de l'étage de convertisseur sigma-delta correspondant et un convertisseur numérique/analogique multibit (11, 13, 22) placé dans la voie de retour, dans lequel les deux étages de convertisseur sigma-delta (1, 2) sont montés en cascade de telle manière qu'un signal d'entrée analogique (X(z)) à convertir en un signal de sortie numérique (Y(z)) est amené au premier étage de convertisseur sigma-delta (1) alors que le signal analogique différentiel entre le signal de sortie du convertisseur analogique/numérique multibit (10) du premier étage de convertisseur sigma-delta (1) converti de numérique en analogique à l'aide d'un premier convertisseur numérique/analogique multibit (15) et le signal d'entrée du convertisseur analogique/numérique multibit (10) du premier étage de convertisseur sigma-delta (1) est amené au second étage de convertisseur sigma-delta (2), de sorte que le signal de sortie numérique (Y(z)) correspondant au signal d'entrée analogique (X(z)) peut être obtenu en combinant les signaux de sortie des convertisseurs analogique/numérique multibit (10, 21) des deux étages de convertisseur sigma-delta (1, 2),
**caractérisé en ce que**
l'ensemble convertisseur sigma-delta analogique /numérique est constitué, de manière appropriée, d'un convertisseur sigma-delta analogique /numérique du troisième ordre,
le premier étage de convertisseur sigma-delta (1) correspond à un convertisseur sigma-delta analogique /numérique du deuxième ordre,
le second étage de convertisseur sigma-delta (2) correspond à un convertisseur sigma-delta analogique /numérique du premier ordre, et un premier intégrateur (6) et un second intégrateur (9) sont placés dans la voie d'aller du premier étage de convertisseur sigma-delta (1), de sorte que le signal analogique différentiel entre le signal d'entrée analogique (X(z)) et le signal de sortie du convertisseur analogique/numérique multibit (10) du premier étage de convertisseur sigma-delta (1) converti de numérique en analogique à l'aide d'un deuxième convertisseur numérique/analogique multibit (13) est amené au premier intégrateur (6) alors que le signal analogique différentiel entre le signal de sortie du premier intégrateur (6) et le signal de sortie du convertisseur analogique/numérique multibit (10) du premier étage de convertisseur sigma-delta (1) converti de numérique en analogique à l'aide d'un troisième convertisseur numérique/analogique multibit (11) est amené au second intégrateur (9), de sorte que le signal de sortie du second intégrateur (9) est amené au convertisseur analogique/numérique multibit (10) du premier étage de convertisseur sigma-delta (1).

2. Ensemble convertisseur sigma-delta analogique /numérique selon l'une quelconque des revendications précédentes,
**caractérisé en ce que**
la largeur de bit des convertisseurs analogique/numérique multibit (10, 21) et des convertisseurs numérique/analogique multibit (11, 13, 15, 22) des deux étages de convertisseur sigma-delta (1, 2) est choisie de telle manière que le signal de sortie numérique (Y(z)) qui peut être obtenu en combinant les signaux de sortie numériques des deux étages de convertisseur sigma-delta (1, 2) correspond au signal de sortie numérique d'un convertisseur sigma-delta avec une quantification de 7 bits.

3. Ensemble convertisseur sigma-delta analogique /numérique selon l'une quelconque des revendications précédentes,
**caractérisé en ce que**
le convertisseur analogique/numérique multibit (21) du second étage de convertisseur sigma-delta (2) est un convertisseur analogique/numérique à 5 bits et le convertisseur numérique/analogique multibit (22) du second étage de convertisseur sigma-delta (2) est un convertisseur numérique/analogique à 5 bits.

4. Ensemble convertisseur sigma-delta analogique /numérique selon l'une quelconque des revendications précédentes,
**caractérisé en ce que**
le convertisseur analogique/numérique multibit (10) du premier étage de convertisseur sigma-delta (1) est un convertisseur analogique/numérique à 3 bits et les convertisseurs numérique/analogique multibit (11, 13, 15) du premier étage de convertisseur sigma-delta (1) sont des convertisseurs numérique/analogique à 3 bits.

5. Ensemble convertisseur sigma-delta analogique /numérique selon l'une quelconque des revendications précédentes,
**caractérisé en ce que**
les signaux de sortie numériques des deux étages de convertisseur sigma-delta (1, 2) sont amenés à un circuit de suppression de bruit (3) qui détecte et émet le signal de sortie numérique (Y(z)) par la combinaison des signaux de sortie numériques des deux étages de convertisseur sigma-delta (1, 2).

6. Ensemble convertisseur sigma-delta analogique /numérique selon la revendication 5,
**caractérisé en ce que**
les deux étages de convertisseur sigma-delta (1, 2) sont placés sur une puce fabriquée suivant un procédé CMOS-0,6 µm.

7. Ensemble convertisseur sigma-delta analogique /numérique selon la revendication 5 ou 6,
**caractérisé en ce que**
le circuit de suppression de bruit (3) comprend un circuit de retard (24) et un circuit de filtre numérique (26),dans lequel
- le signal de sortie numérique du premier étage de convertisseur sigma-delta (1) est amené au circuit de retard (24),
- le signal de sortie numérique du second étage de convertisseur sigma-delta (2) est amené au circuit de filtre numérique (26), et
- le circuit de suppression de bruit (3) sort la différence entre le signal de sortie du circuit de retard (24) et le signal de sortie du circuit de filtre numérique (26) comme le signal de sortie numérique (Y(z)).

8. Ensemble convertisseur sigma-delta analogique /numérique selon l'une quelconque des revendications précédentes,
**caractérisé en ce que**
les convertisseurs analogique/numérique multibit (10, 21) des deux étages de convertisseur sigma-delta (1, 2) sont formés par des convertisseurs à mémoire instantanée.

9. Ensemble convertisseur sigma-delta analogique /numérique selon l'une quelconque des revendications précédentes,
**caractérisé en ce que**
les deux étages de convertisseur sigma-delta (1, 2) sont réalisés par la technique Switched Capacitor.

10. Ensemble convertisseur sigma-delta analogique /numérique selon la revendication 9,
**caractérisé en ce que**
le premier étage de convertisseur sigma-delta (1) est formé par une structure condensateur commuté non canonique et le second étage de convertisseur sigma-delta (2) est formé par une structure condensateur commuté canonique.
